# DEMANDE DE BREVET EUROPEEN

(11) **EP 0 858 252 A1**
(43) Date de publication de la demande: **12.08.1998**
(21) Numéro de dépôt: 98400267.5
(22) Date de dépôt: 06.02.1998
(51) Int. Cl.: H05K 3/06, H05K 3/42

(54) **Procédé de réalisation de circuits imprimés à double épargne**

(30) Priorité: 11.02.1997 FR 9701557
(71) Demandeur: THOMSON-CSF, 75008 Paris (FR)
(72) Inventeur: Prevotat, Olivier, 94117 Arcueil Cedex (FR); Lhermitte, Jean-André, 94117 Arcueil Cedex (FR)

(57) **Abrégé**

La présente invention conceme un procédé de réalisation de circuits imprimés à double épargne.

La surface du substrat (1) étant préalablement recouverte d'un métal de base (2), il comporte au moins deux opérations de métallisation, durant la première opération une épargne métallique (5) étant déposée sur la couche de base (2) et dessinant au moins les motifs (4) des éléments de circuit nécessitant une gravure précise, durant la deuxième opération les autres motifs du circuit étant recouverts d'une deuxième épargne (11).

Application : notamment pour la réalisation de circuits imprimés comportant une fonction hyperfréquence et/ou numérique ou pour la réalisation de circuits imprimés destinés à interconnecter des composants présentant des finitions et/ou des technologies de câblage différentes.

## Description

La présente invention concerne un procédé de réalisation de circuits imprimés à double épargne. Elle s'applique notamment dans des cas de réalisation de circuits à trous métallisés où sont recherchées des précisions de gravure élevées. Plus généralement, elle s'applique à des circuits présentant à la fois des motifs nécessitant une grande épaisseur de métal et des motifs nécessitant une gravure précise. Elle s'applique encore par exemple dans le cas où deux finitions différentes sont nécessaires pour le câblage des composants.

Certaines applications telles que par exemple les fonctions hyperfréquence demandent une très grande précision de gravure des circuits imprimés, c'est le cas par exemple de fonctions de filtrage hyperfréquence réalisées par des pistes juxtaposées et qui exigent une très grande précision tant au niveau de la largeur de ces dernières qu'au niveau de la distance les séparant. D'autres applications nécessitent aussi une gravure très précise, c'est par exemple le cas notamment lorsqu'il faut prévoir des plages d'accueil pour des composants et donc un câblage précis ainsi qu'une disposition précise de ceux-ci par rapport à des pistes ou à d'autres composants. Tous ces circuits nécessitent par ailleurs des trous métallisés, notamment par exemple pour la connexion à des composants ou à des fonctions discrets ou encore pour la connexion à d'autres circuits imprimés ou à d'autres sous-ensembles.

En ce qui concerne la réalisation de circuits imprimés à trous métallisés, au moins deux procédés de réalisation sont connus. Dans le cas d'application d'un premier procédé, de type additif car entraînant un ajout de cuivre, le matériau de base est métallisé sélectivement, tandis que dans le cas d'un second procédé, le matériau de base est préalablement entièrement recouvert d'un feuillard métallique puis est gravé sélectivement, ce second cas est dit de type soustractif car du cuivre est enlevé par rapport au cuivre de base. Deux variantes du procédé soustractif sont connus selon les expressions anglo-saxonnes "panel plating" et "pattern plating", la première signifiant une métallisation du panneau et la seconde signifiant une métallisation du motif.

Le procédé "pattern plating" présente comme avantage principal le fait que le dépôt de cuivre électrolytique final n'est effectué que sur les circuits électroniques. L'épaisseur de cuivre à graver est donc limitée à l'épaisseur de cuivre de base à laquelle s'ajoute l'épaisseur du premier dépôt. Malheureusement, il est fréquent d'observer des écarts importants dans l'épaisseur de métal déposé lors du premier dépôt de cuivre. Ainsi, des zones de circuits denses sont recouvertes de moins de métal que des zones de circuits moins denses, les parties moins recouvertes étant alors trop gravées.

Le principal inconvénient du procédé "panel plating" est que l'épaisseur de cuivre à graver, pour une épaisseur de cuivre dans les trous égale, est plus importante que dans le cas d'application du procédé "pattern plating". De plus, si un produit photosensible de type dit "négatif" est utilisé, les parties du film exposées à la lumière étant polymérisées et donc persistant sur le circuit après développement, ce film est tendu au dessus des trous métallisés pour les protéger de l'agent de gravure. Il existe alors un risque de gravure indésirable du cuivre dans les trous si le film photosensible se fissure, risque qui n'existe pas dans le cas du procédé "pattern plating" car dans ce cas, au moment de la gravure il n'y a plus de film photosensible.

Dans le cas du "pattern plating" il est de toute façon indispensable, pour métalliser les trous, de déposer une épaisseur de métal de plusieurs microns, typiquement 5 µm, sur toute la surface du panneau. En effet, pour rendre les trous conducteurs, une très fine couche de métal est déposée de façon dite chimique, cette couche étant immédiatement recouverte d'une seconde couche de métal de façon dite électrolytique. Or, le dépôt chimique ne peut être réalisé sélectivement. Donc même dans le cas du "pattern plating", l'épaisseur de métal à graver est supérieure à l'épaisseur du métal de base.

Dans le cas d'application d'un procédé soustractif, la précision de gravure est directement fonction de l'épaisseur du cuivre à graver. Si une précision est recherchée au niveau des circuits, il est nécessaire de diminuer les épaisseurs des dépôts métalliques. Or en diminuant ces épaisseurs, l'épaisseur de métal dans les trous métallisés est également diminuée. Cela entraîne une diminution de la fiabilité du circuit imprimé car la résistance des trous métallisés aux contraintes thermo-mécaniques est directement liée à l'épaisseur de métal déposé.

Le procédé additif permet de s'affranchir des problèmes liés à la précision de gravure, mais il ne permet pas d'obtenir une adhérence suffisante du cuivre sur le substrat pour des applications contraignantes du point de vue thermique et/ou mécanique. Ce procédé est de plus très délicat à mettre en oeuvre, et beaucoup moins répandu que le procédé soustractif.

L'invention a pour but de pallier les inconvénients précités. Elle a notamment pour but d'assurer une précision de gravure sans que l'épaisseur de métal déposé dans les trous ne soit limitée. A cet effet, l'invention a pour objet un procédé de réalisation d'un circuit imprimé, caractérisé en ce que la surface de ce dernier étant préalablement recouverte d'un métal de base, il comporte au moins deux opérations de métallisation, durant la première opération une épargne métallique étant déposée sur la couche de base et dessinant au moins les motifs des éléments de circuit nécessitant une gravure précise, durant la deuxième opération les autres motifs du circuit étant recouvert d'une deuxième épargne.

L'invention a pour principaux avantages qu'elle permet une mixité des types de composants et des technologies de câblage, qu'elle s'adapte à des circuits numériques dont la fréquence de fonctionnement ne cesse de s'accroître, qu'elle s'adapte à des circuits hyperfréquence, qu'elle s'adapte à des circuits imprimés mélangeant une fonction hyperfréquence et une fonction numérique, qu'elle s'applique aussi bien à des circuits imprimés monocouche qu'à des circuits imprimés multicouches, et qu'elle est simple à mettre en oeuvre.

D'autres caractéristiques et avantages de l'invention apparaîtront à l'aide de la description qui suit faite en regard de dessins annexés qui représentent:
- les figures 1 à 10, une illustration d'un exemple d'une suite d'étapes possibles du procédé selon l'invention, appliquée à titre d'exemple à la réalisation d'un circuit imprimé à double face ;
- la figure 11, un exemple de circuit imprimé multicouche réalisé par le procédé selon l'invention.

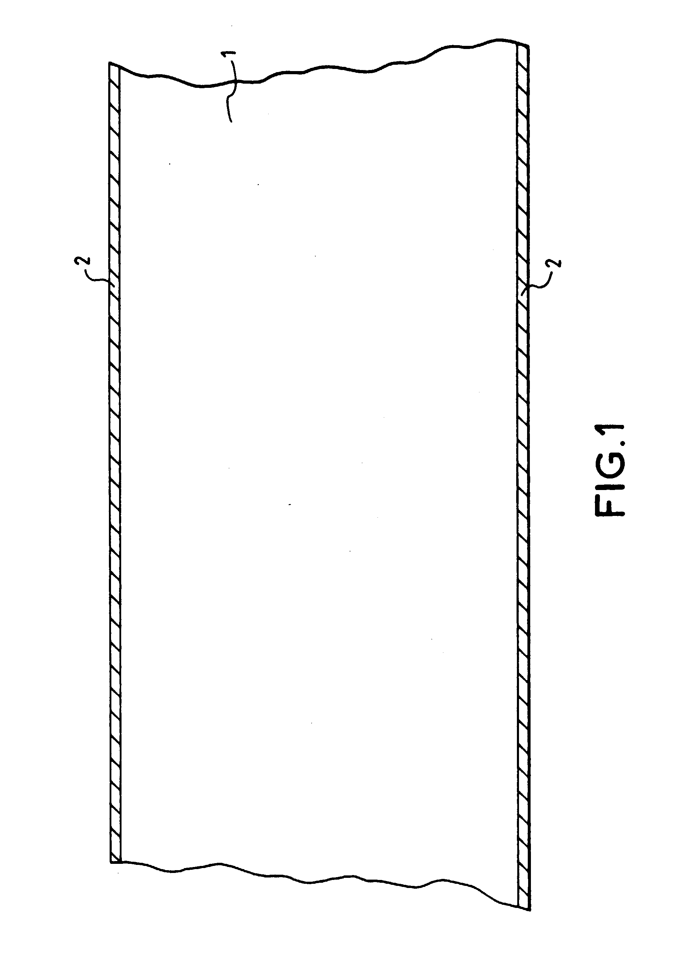

La figure 1 présente une partie d'une plaque en matériau diélectrique 1 recouverte sur ces deux faces d'une couche de cuivre de base 2 et destinée à la réalisation d'un circuit imprimé, à double face à titre d'exemple. Sauf indication contraire, il sera toujours fait référence à cette même partie 1,2 pour décrire un exemple de mise en oeuvre possible du procédé selon l'invention.

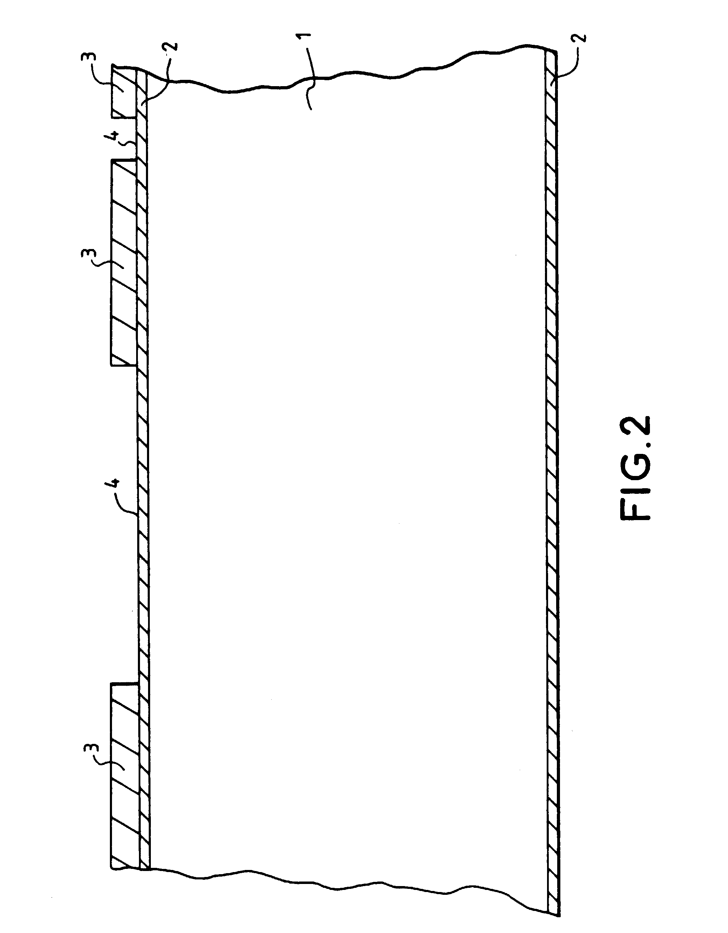

La figure 2 illustre une première étape du procédé selon l'invention. La couche de base 2 est recouverte d'un produit photosensible 3 dit négatif. Il est bien entendu possible d'utiliser un produit photosensible dit positif ou tout autre produit pouvant être déposé sélectivement tel qu'un produit pouvant être sérigraphié par exemple. Les parties de surface 4 destinées à une gravure précise sont seules à ne pas subir une insolation de telle sorte qu'après le développement du produit photosensible ces parties 4 précitées ne soient pas recouvertes d'un film 3. Ce dernier protège les parties non concernées par la précision des opérations effectuées dans les deux étapes suivantes. Les parties de surface 4 destinées à une gravure précise sont par exemple des plages d'accueil ou des pistes prévues par exemple pour des fonctions hyperfréquence et/ou numériques.

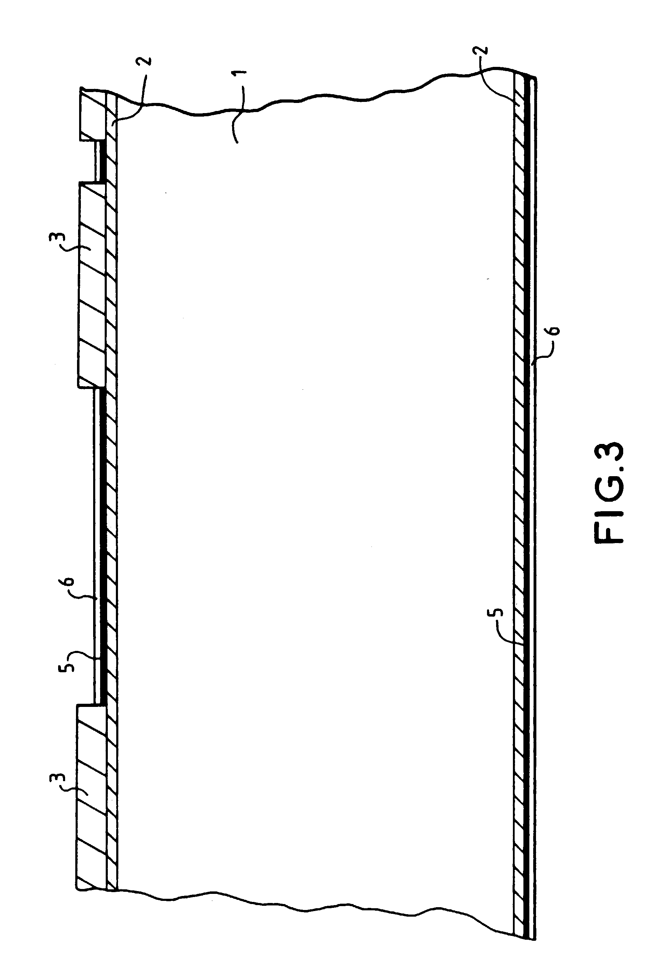

La figure 3 illustre une deuxième et une troisième étapes du procédé selon l'invention. Dans la deuxième étape, la surface à gravure précise est recouverte d'une couche d'or 5 par dépôt électrolytique. Dans la troisième étape, la couche d'or 5 est par exemple recouverte, après son dépôt, d'une couche de cuivre 6 par dépôt électrolytique. Un avantage apporté par le recouvrement de la couche d'or 5 par la couche de cuivre 6 est que cela permet notamment de procéder à d'autres opérations telles que par exemple la préparation des autres surfaces sans endommager la couche d'or.

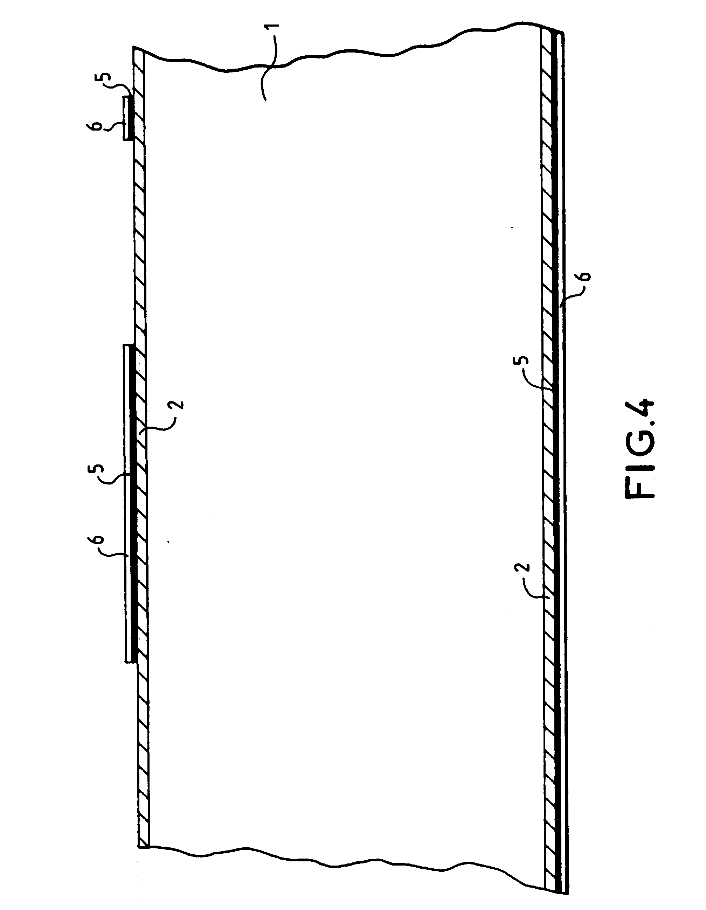

La figure 4 illustre une quatrième étape du procédé où le produit photosensible est supprimé de la surface du circuit imprimé.

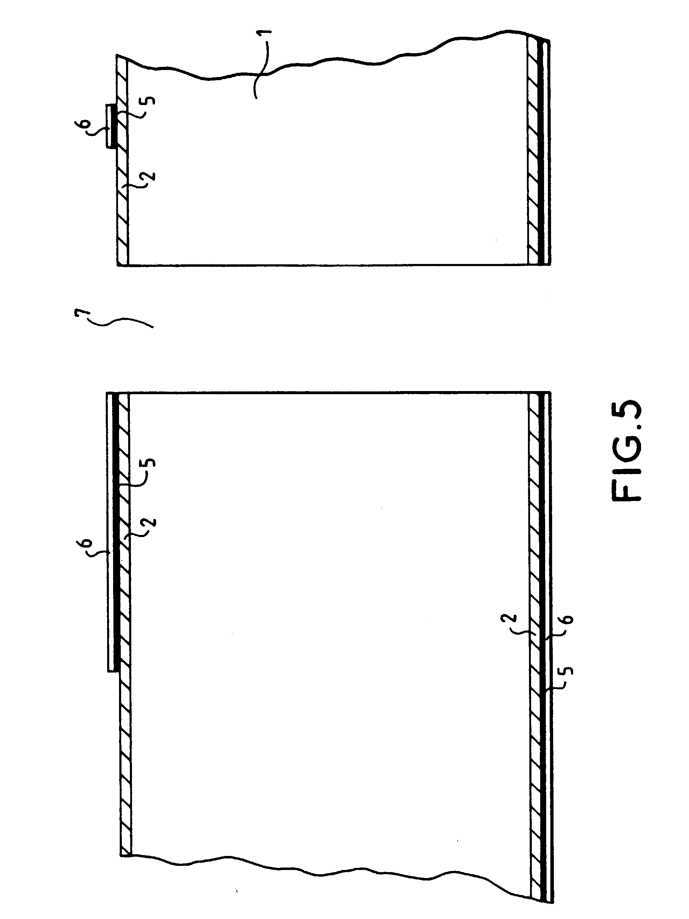

La figure 5 illustre une cinquième étape dans laquelle est effectué le perçage des trous 7 à réaliser.

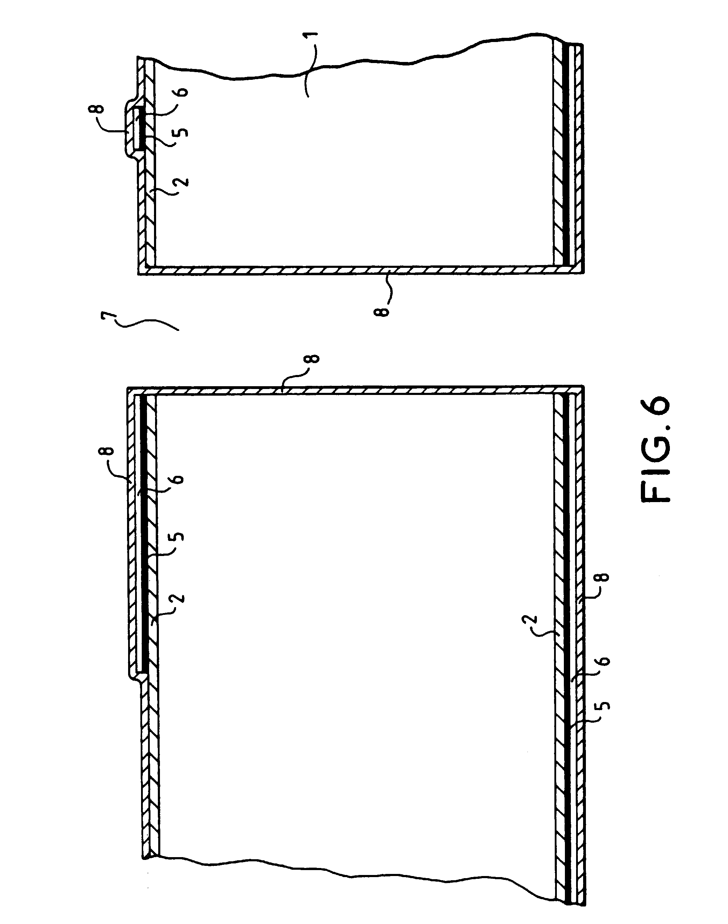

La figure 6 illustre une sixième étape du procédé selon l'invention. Dans cette étape, toute la surface y compris celle à l'intérieur des trous 7 et y compris celle destinée à une gravure précise est recouverte d'un dépôt de cuivre chimique puis d'un dépôt de cuivre électrolytique 8. Le dépôt de cuivre chimique préalablement au dépôt de cuivre électrolytique est notamment nécessaire à cause du fait qu'un dépôt électrolytique n'est pas possible directement sur un matériau diélectrique, ce dernier étant un isolant électrique. De plus, le dépôt chimique ne peut assurer seul une couche de cuivre par manque de tenue mécanique. Par ailleurs, le dépôt chimique contrairement au dépôt électrolytique ne permet pas un dépôt sélectif. En effet, dans le dépôt électrolytique la sélection des surfaces étant obtenue par masquage, la sélection est possible. L'épaisseur totale de ce dépôt, chimique et électrolytique, peut par exemple être de l'ordre de 5 µm.

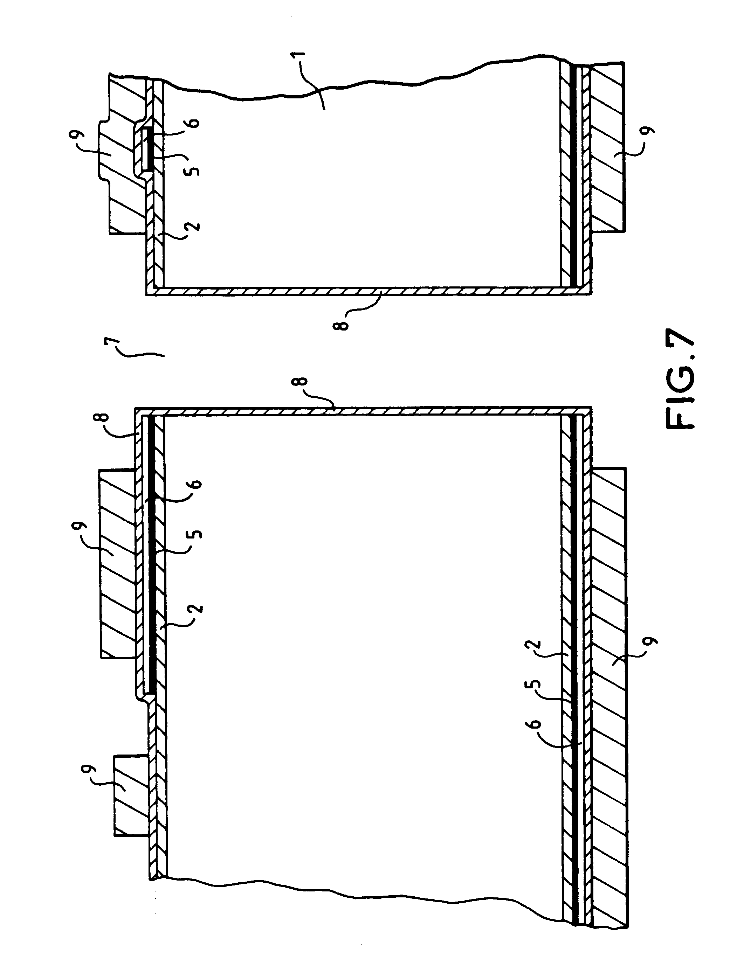

La figure 7 illustre une septième étape du procédé selon l'invention. Un produit protecteur 9, par exemple un film photosensible négatif, est disposé de façon à recouvrir les surfaces à gravure précise, destinées par exemple à des plages d'accueil de composants et des liaisons associées ainsi qu'à des pistes aux dimensions et aux espacements précis. Pour cela, après dépôt d'un produit photosensible, une insolation de ces surfaces est réalisée de telle sorte qu'elles soient recouvertes, après développement, d'un film photosensible polymérisé 9. Cette insolation n'est pas effectuée sur des pastilles de connexion relatives à des trous métallisés ainsi que sur d'autres éléments de circuit nécessitant de fortes épaisseurs de métal telles que certaines plages d'accueil de composants ou des lignes de puissance.

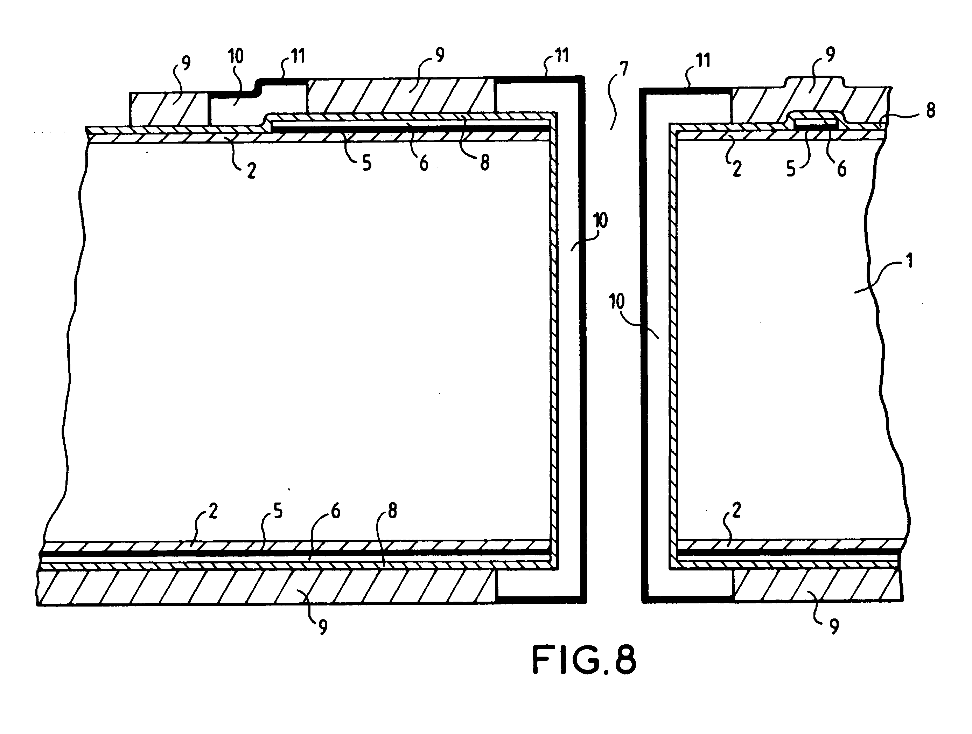

La figure 8 illustre une huitième étape du procédé selon l'invention. Dans cette étape, après le développement du produit photosensible 9, au moins une couche de dépôt électrolytique de cuivre est réalisée sur les surfaces non recouvertes de film photosensible. L'épaisseur du dépôt peut par exemple atteindre 25 µm. Un dépôt électrolytique 11 d'un métal servant de masque de gravure est par exemple effectué sur le précédent 10. Cette dernière couche 11 peut par exemple servir de deuxième couche de finition, la première couche de finition étant la couche de métal 5. Cette couche 11 est par exemple en étain-plomb, en or ou en étain.

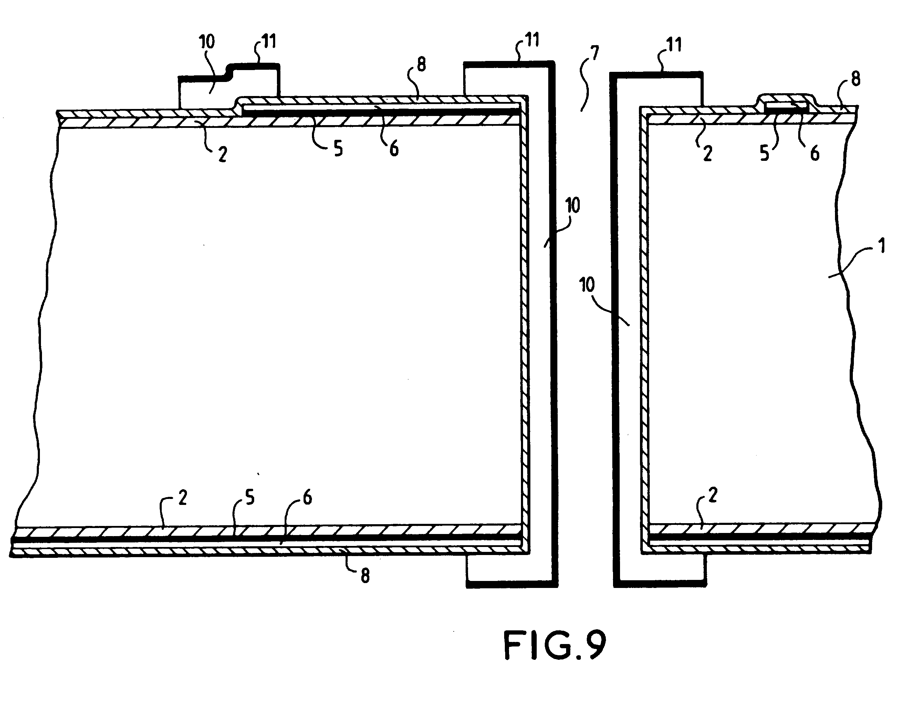

La figure 9 illustre une neuvième étape du procédé selon l'invention où le film photosensible polymérisé 9 est retiré.

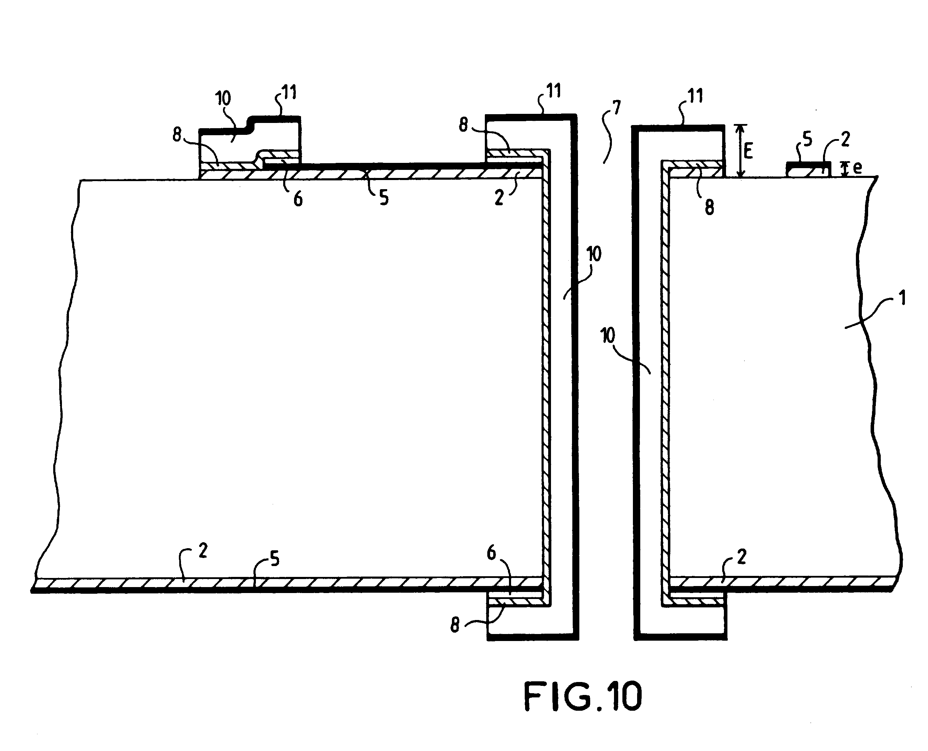

La figure 10 illustre la dernière étape, de gravure, en montrant un des avantages du procédé selon l'invention, notamment apporté par sa deuxième étape où la surface à gravure très précise est recouverte d'une couche d'or. Suite aux étapes précédentes, la figure 10 montre en effet que l'épaisseur e de métal à graver est faible au niveau des surfaces recouvertes de la couche d'or, la seule couche à graver étant par exemple le cuivre de base 2. Cette faible épaisseur permet une grande précision de gravure puisque cette précision est fonction de l'épaisseur à graver, plus l'épaisseur étant faible, plus la précision obtenue étant grande. Par ailleurs, les autres parties de circuits imprimés, notamment les trous métallisés 7 et certaines plages d'accueil de composants ont une couche de métal ayant une épaisseur E élevée. Une fiabilité de la couche de métal dans les trous métallisés et une précision de gravure pour les pistes sensibles sont donc à la fois obtenues.

En fait le procédé selon l'invention comporte au moins deux opérations de métallisation de façon à obtenir au moins deux épargnes métalliques, une épargne étant une couche de protection empêchant une partie du circuit d'être attaquée par le produit de gravure. La première épargne sert notamment de protection au cuivre 2 de la partie à graver avec précision, par exemple des pistes, et la seconde épargne sert de protection aux autres parties, par exemple les trous métallisés ou des pastilles associées. La première opération de métallisation permet de déposer sur le métal de base 2, en cuivre par exemple, une couche de métal 5 dessinant au moins les motifs des éléments de circuit nécessitant une gravure précise, cette couche 5 constitue une première épargne. Puis les autres éléments du circuit, notamment les trous métallisés, sont réalisés, c'est-à-dire notamment percés, métallisés et rechargés. Durant cette phase, entre les deux opérations de métallisation, sont en fait notamment créés des motifs 10 de circuit à grande épaisseur de métal. Ensuite la deuxième opération de métallisation est engagée. Lors de cette deuxième opération, la première couche métallique 5 est recouverte en partie par une autre couche métallique 11 qui recouvre par ailleurs les autres motifs du circuit, cette couche sert comme deuxième épargne. Ainsi il existe deux épargnes de gravure. La première 5 protège les motifs de circuit à graver avec précision et la deuxième 11 protège les autres éléments du circuit, par exemple les fûts des trous ou autres éléments nécessitant une grande épaisseur de métal. Il est à noter en particulier que le perçage des trous 7 ayant été effectué entre les deux opérations de dépose d'une épargne métallique 5, 11, la surface intérieure des trous est recouverte par la deuxième épargne 11. Le fait de percer puis de métalliser les trous entre les deux opérations de dépôt d'une épargne 5, 11 permet de n'avoir à graver que la couche de base 2, notamment pour les gravures de précision. En effet, si par exemple les trous métallisés étaient effectués avant la première opération de métallisation, la couche 8 de métallisation des trous serait superposée à la couche de base 2, y compris pour les zones nécessitant une grande précision de gravure. La couche globale à graver serait donc, pour ces dernières, plus épaisse, ce qui va à l'encontre de la précision. La gravure est réalisée après le dépôt de la deuxième épargne 11. Les deux métaux utilisés comme épargnes peuvent être identiques ou différents pour accommoder les finitions des composants.

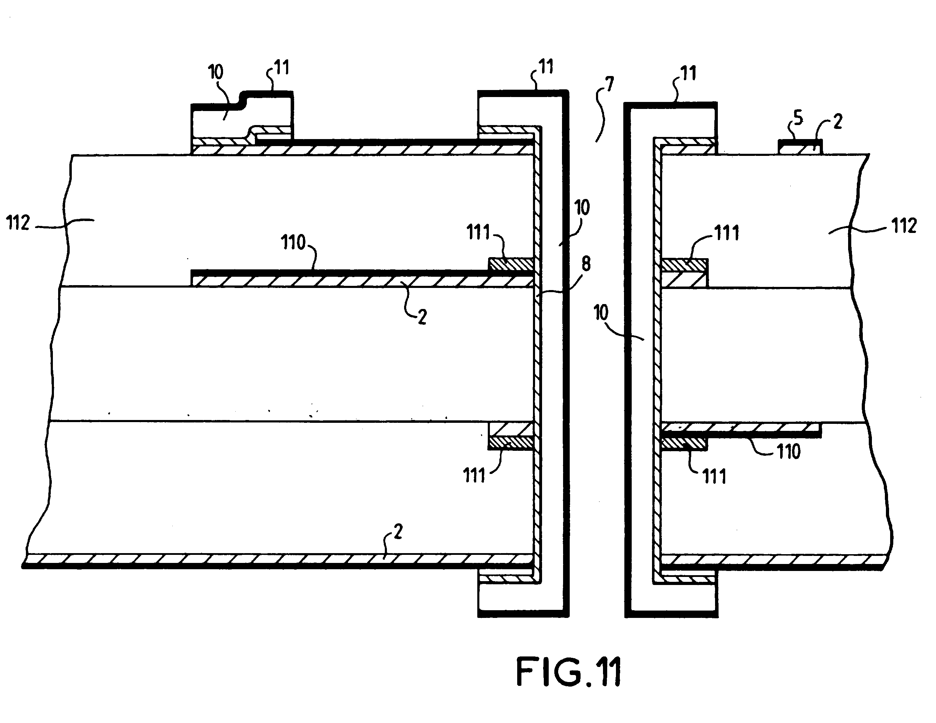

La figure 11 montre une application avantageuse du procédé selon l'invention, cette application concerne la réalisation d'un circuit imprimé multicouche. Un tel circuit imprimé comporte par exemple des lignes 110 internes à impédance imposée, ce qui demande notamment une grande précision de gravure. En même temps, pour assurer une fiabilité des liaisons électriques au niveau des trous, des pastilles 111 ayant une grande épaisseur de métal sont nécessaires à l'interface des lignes et de la couche conductrice 8,10,11 des trous 7, une grande surface de contact permettant d'assurer une bonne liaison électrique. Dans ce cas, le procédé selon l'invention appliqué à chaque sous-couche 112 concernée permet d'obtenir à la fois une précision de gravure pour les pistes à impédance imposée et une couche de métal importante pour les pastilles dédiées à la connexion via les trous.

Le procédé selon l'invention peut encore être appliqué à la réalisation de circuits imprimés destinés à des fonctions numériques combinant ou non des fonctions hyperfréquence. Plus généralement, il peut être appliqué à des circuits numériques dont la fréquence de fonctionnement est de plus en plus élevée dans la mesure où l'impédance électrique doit être parfaitement maîtrisée. Par ailleurs, ces circuits numériques nécessitent des circuits imprimés multicouche étant donné le nombre très élevé d'interconnexions en jeu. Le procédé selon l'invention permet encore de mixer plusieurs technologies de câblage. En effet, il permet par exemple de graver des plages d'accueil, pour des composants en boîtier classique, avec des lignes de connexion précises puis de réaliser une deuxième finition avec ajout de métal nécessaire notamment pour des composants à monter en surface. De la même façon le procédé selon l'invention permet de mélanger une technologie dite "chip on board" où les puces sont directement câblées sur le circuit imprimé avec une technologie de câblage classique pour des composants classiques et/ou à monter en surface, toujours grâce à la possibilité d'obtenir à la fois des éléments de surface avec une gravure précise et des éléments de surface à forte épaisseur de métal, et la possibilité de mixer deux finitions différentes sur une même face d'un circuit.

Dans l'exemple de d'application présenté relativement aux figures 1 à 10, les éléments de surface à graver avec précision sont enterrés en n'ayant au dessous d'eux que le cuivre de base 2, pour cela ils sont recouverts d'une couche d'or 5 constituant la première épargne. L'or a été utilisé à titre d'exemple de réalisation, il est bien entendu que d'autres métaux peuvent être employés, par exemple le nickel ou l'argent. Enfin l'invention est simple à mettre en oeuvre en regard de la grande fiabilité de réalisation qu'elle apporte. Par ailleurs, elle peut être appliquée sur tous types de circuits imprimés, qu'ils soient à une ou deux faces, ou multicouches.

## Revendications

1. Procédé de réalisation d'un circuit imprimé, caractérisé en ce que la surface de ce dernier (1) étant préalablement recouverte d'un métal de base (2), il comporte au moins deux opérations de métallisation, durant la première opération une épargne métallique (5) étant déposée sur la couche de base (2) et dessinant au moins les motifs (4) des éléments de circuit nécessitant une gravure précise, durant la deuxième opération les autres motifs du circuit étant recouverts d'une deuxième épargne (11), des trous métallisés (7) étant réalisés entre les deux opérations de métallisation.

2. Procédé selon la revendication 1, caractérisé en ce qu'entre les deux opérations de métallisation, outre des trous métallisés, des motifs (10) de circuit à grande épaisseur de métal sont réalisés.

3. Procédé selon l'une quelconque des revendications précédentes, caractérisé en ce que la première épargne (5) est, après son dépôt, recouverte d'une couche de cuivre (6).

4. Procédé selon l'une quelconque des revendications 2 ou 3, caractérisé en ce que pour la réalisation des motifs à grande épaisseur de métal ou la réalisation des trous, il comporte une étape de dépôt d'un produit protecteur (9) sur les motifs à graver avec précision, suivie d'une étape de dépôt de métal (10) sur les surfaces non recouvertes du produit protecteur (9) suivie d'une étape où ce produit est retiré.

5. Procédé selon la revendication 4, caractérisé en ce que le métal (10) est du cuivre déposé de façon électrolytique.

6. Procédé selon l'une des revendications 4 ou 5, caractérisé en ce que la réalisation des motifs à grande épaisseur ou la réalisation des trous débute par une étape où la surface du circuit, y compris celle à graver précisément ou la surface interne des trous, sont recouvertes d'une couche de métal (8).

7. Procédé selon la revendication 6, caractérisé en ce que la couche (8) est en cuivre.

8. Procédé selon l'une des revendications 2 à 7, caractérisé en ce que le métal déposé (10) pour la réalisation des motifs à grande épaisseur de métal est recouvert de la deuxième épargne métallique (11).

9. Procédé selon la revendication 8, caractérisé en ce que la deuxième épargne (11) sert aussi de couche de finition.

10. Procédé selon l'une quelconque des revendications précédentes, caractérisé en ce que la première épargne (5) est en or.

11. Procédé selon l'une quelconque des revendications précédentes, caractérisé en ce que la deuxième épargne (11) est en or.

12. Procédé selon la revendication 9, caractérisé en ce que la deuxième épargne (11) contient de l'étain.

13. Procédé selon l'une quelconque des revendications précédentes, caractérisé en ce que le métal de base est du cuivre.
